# EUROPÄISCHE PATENTSCHRIFT

(11) **EP 1 704 323 B1**
(45) Veröffentlichungstag und Bekanntmachung des Hinweises auf die Patenterteilung: **19.11.2008**
(21) Anmeldenummer: 05701483.9
(22) Anmeldetag: 11.01.2005
(51) Int. Cl.: F02M 51/06, F02M 61/16

(54) **PIEZOAKTOR MIT MITTELN ZUR KOMPENSATION DER THERMISCHEN LÄNGENÄNDERUNG UND KRAFTSTOFF-EINSPRITZVENTIL MIT PIEZOAKTOR**
PIEZO ACTUATOR COMPRISING MEANS FOR COMPENSATING THERMAL LENGTH MODIFICATIONS AND FUEL-INJECTION VALVE COMPRISING A PIEZO ACTUATOR
ACTIONNEUR PIEZOELECTRIQUE COMPORTANT DES MOYENS POUR COMPENSER UN CHANGEMENT DE LONGUEUR THERMIQUE, ET SOUPAPE D'INJECTION DE CARBURANT COMPORTANT CET ACTIONNEUR PIEZOELECTRIQUE

(30) Priorität: 12.01.2004 DE 102004001679
(43) Veröffentlichungstag der Anmeldung: 27.09.2006
(73) Patentinhaber: Continental Automotive GmbH, 30165 Hannover (DE)
(72) Erfinder: DICK, Jürgen, 93164 Laaber (DE); LIXL, Heinz, 93053 Regensburg (DE); SIMMET, Martin, 93077 Bad Abbach (DE)
(86) Internationale Anmeldenummer: PCT/EP2005/050092
(87) Internationale Veröffentlichungsnummer: WO 2005/066486

(56) Entgegenhaltungen:
- EP-A- 0 869 278
- DE-A1- 10 159 748
- DE-A1- 19 538 791
- DE-A1- 19 807 903

## Beschreibung

Die Erfindung betrifft einen Piezoaktor und ein Kraftstoff-Einspritzventil für eine Brennkraftmaschine mit einer fest mit einem Ventilgehäuse verbundenen Aktoreinheit, die mindestens einen unter Vorspannung in ein Aktorgehäuse eingebrachten Piezoaktor aufweist, wobei zwischen dem Piezoaktor und einer Kopfplatte des Aktorgehäuses ein Ausgleichselement zum Ausgleich der unterschiedlichen thermischen Längenänderung des Piezoaktors gegenüber dem Aktorgehäuse angeordnet ist.

Ein derartiges Einspritzventil ist bereits aus der EP 0 869 278 A1 bekannt.

Für die Kraftstoffversorgung von Verbrennungsmotoren werden zunehmend Hochdruck-Speichereinspritzsysteme verwendet. Solche Einspritzsysteme sind als Common-Rail-Systeme (für Dieselmotoren) und HPDI-Einspritzsysteme (für Ottomotoren) bekannt. Bei diesen Einspritzsystemen wird der Kraftstoff mit einer Hochdruckpumpe in einen allen Zylindern des Motors gemeinsamen Druckspeicher gefördert, von dem aus die Einspritzventile an den einzelnen Zylindern versorgt werden. Die Steuerung des Öffnens und Schließens der Einspritzventile kann elektromagnetisch oder elektrisch erfolgen; im vorliegenden Fall werden dazu elektrische Piezoaktuatoren herangezogen.

Die bei Ansteuerung des Piezoaktors erfolgende Ausdehnung in axialer Richtung wird ausgenutzt, um über eine direkte oder indirekte Wirkverbindung mit der Einspritznadel des Ventils die Einspritznadel zum Einspritzen von Kraftstoff zu steuern, wobei eine relativ empfindliche Justierung zwischen Piezoaktor und Einspritzventil vorausgesetzt ist. Durch die unterschiedlichen thermischen Ausdehnungskoeffizienten der Piezokeramik und der umgebenden Materialien ergibt sich das Problem, die durch den notwendigen weiten Temperaturarbeitsbereich bei einem Fahrzeug hervorgerufenen unterschiedlichen Längenausdehnungen zu kompensieren, um eine Dejustierung des Ventilhubs zu vermeiden.

Neben dem früher üblichen hydraulischen Ausgleichselement sind inzwischen auch verschiedene nichthydraulische Maßnahmen zum Ausgleich der Längenausdehnung.des Piezoaktors und eines umgebenden Aktorgehäuses bzw. Ventilgehäuses bekannt. Beispielsweise ist aus der DE 195 38 791 C2 ein Piezosteuerventil bekannt, bei dem das Ventilgehäuse selbst als zweiteilige Hülse mit axial hintereinander angeordneten Hülsenteilen ausgebildet ist, die aus verschiedenen Werkstoffen mit unterschiedlichen Ausdehnungskoeffizienten bestehen. In der gattungsgemäßen Patentanmeldung EP 0 869 278 A1 werden zwei weitere, auch voneinander unabhängige, jedoch kombinierbare Ausgleichsmöglichkeiten genannt. Zum einen wird vorgeschlagen, für das Material des den Aktor umgebenden Aktorgehäuses einen Ausdehnungskoeffizienten zu wählen, der nahezu gleich dem Ausdehnungskoeffizient des Piezoaktors ist. Zum anderen wird mindestens eine zwischen dem Piezoaktor und der Deckplatte des Aktorgehäuses angeordnete Ausgleichsscheibe mit relativ hohem Ausdehnungskoeffizienten vorgeschlagen, die geeignet ist, den geringeren Ausdehnungskoeffizient des Piezoaktors gegenüber dem Aktorgehäuse auszugleichen.

Eine besondere Problematik der beschriebenen Temperaturkompensation tritt im Zusammenhang mit der notwendigen Vorspannung des Piezoaktors im Aktorgehäuse auf. Da Zugspannungen im piezokeramischen Aktormaterial unbedingt zu vermeiden sind, wird der unbestromte Piezoaktor mittels Federkraft in definierter Weise vorgespannt. Der bestromte Piezoaktor muss sich also gegen diese Vorspannung ausdehnen. Typischerweise wird zur Erzeugung dieser Vorspannung, wie in der gattungsgemäßen EP 0 869 278 A1 beschrieben, eine zwischen der Bodenplatte des Aktorgehäuses und der zugeordneten Stirnseite des Piezoaktors angeordnete Feder eingesetzt, die den Aktor gegen die Kopfplatte des Aktorgehäuses drückt und somit vorspannt. Ebenfalls beschrieben ist die Möglichkeit, eine derartige Vorspannfeder, bzw. ein zugeordnetes Stellglied, über die Materialwahl in die Kompensation der unterschiedlichen Längenausdehnung einzubeziehen.

Es sind jedoch auch Injektoren bekannt, bei denen der Piezoaktor innerhalb einer Rohrfeder aus Stahl vorgespannt ist, die an einer Seite mit einer Kopfplatte und gegenüberliegend, unter Vorspannung, mit einer Bodenplatte verschweißt ist. Die aus diesem "Gehäuse", zusammen mit dem darin unter Vorspannung eingebrachten Piezoaktor, gebildete Aktoreinheit wird mit einem Ventilgehäuse fest verbunden bzw. in einen Injektorkörper eingebaut. Die bekannten Maßnahmen zur Kompensation der unterschiedlichen Längenausdehnung sind bei dieser Konstruktion nicht ohne weiteres anwendbar. Andererseits muss eine Kompensation zwischen Piezoaktor und "Rohrfeder-Gehäuse" erfolgen, da sich sonst eine temperaturabhängige Änderung der Vorspannung und damit ein unerwünschtes, temperaturabhängiges Ansprechverhalten des Einspritzventils ergeben würde.

Der Erfindung liegt daher die Aufgabe zu Grunde, bei einem gattungsgemäßen Einspritzventil auch dann mit geringem baulichen Aufwand eine temperaturkonstante Vorspannung sicherzustellen, wenn der Piezoaktor unter Vorspannung in eine Rohrfeder eingebracht ist.

Diese Aufgabe wird erfindungsgemäß durch einen Piezoaktor gemäß Anspruch 1 und ein Einspritzventil gemäß Anspruch 9 gelöst. Vorteilhafte Ausführungen der Erfindung sind den Unteransprüchen 2 bis 8 entnehmbar.

Erfindungsgemäß ist der Piezoaktor bei einem gattungsgemäßen Einspritzventil innerhalb einer Rohrfeder angeordnet. Außerdem ist das Ausgleichselement als innerhalb eines Verlängerungsrohres angeordneter Ausgleichszylinder ausgebildet. Das Aktorgehäuse umfasst eine zweiteilige, aus der Rohrfeder und dem damit fest verbunden Verlängerungsrohr bestehende Hülse, deren verlängerungsrohrseitiges Ende fest mit der Kopfplatte und deren rohrfederseitiges Ende, unter Aufbringung einer definierten Vorspannung auf die innerhalb der Hülse axial hintereinander angeordneten Teile, fest mit einer Bodenplatte des Aktorgehäuses verbunden ist.

Der Erfindung liegt demnach der Gedanke zu Grunde, den Piezoaktor und den Ausgleichszylinder in Reihe in einem "Aktorgehäuse" zu montieren und gemeinsam mittels einer zum "Aktorgehäuse" verlängerten Rohrfeder vorzuspannungen. Das Aktorgehäuse besteht aus Kopfplatte, Verlängerungsrohr, Rohrfeder und Bodenplatte. Daraus ergibt sich ein Aufbau, bei dem die Summe der Wärmeausdehnungen der inneren Teile (Piezokeramik plus Material des Ausgleichszylinders) gleich der Wärmeausdehnung des Aktorgehäuses ist. Dadurch ändert sich die bei der Montage eingestellte Vorspannung auf die Piezokeramik bei Temperaturänderung nur unwesentlich. Außerdem ergibt sich ein stabiler Aufbau der Aktoreinheit, der insbesondere deren stabile Fixierung im Ventilgehäuse ermöglicht.

Bei einer Ausführungsform der Erfindung ist es von Vorteil, wenn die Teile des Aktorgehäuses aus Stahl bestehen, das Aktorgehäuse sich also in allen Teilen gleichmäßig und insgesamt auf definierte Weise ausdehnt.

Es ist weiterhin von Vorteil, die Teile des Aktorgehäuses an den Verbindungsstellen miteinander zu verschweißen, um die erforderliche Festigkeit der Verbindungen zwischen den Teilen des Aktorgehäuses zu erreichen.

Gemäß einer besonders bevorzugten Ausführungsform der Erfindung besteht der Ausgleichszylinder aus Aluminium. Dieses Material verbindet das angestrebte Ausdehnungsverhalten mit einer vorteilhaft hohen Festigkeit sowie einem niedrigen Gewicht.

Das Ausdehnungsverhalten der inneren Teile bzw. die Geometrie der Aktoreinheit insgesamt kann auf einfache Weise dadurch beeinflusst werden, dass zwischen Piezoaktor und Ausgleichszylinder eine Zwischenscheibe angeordnet ist.

Es ist von Vorteil, dass im Umfang des Verlängerungsrohres Durchbrüche eingearbeitet sind, in die jeweils ein Federblech derart montiert ist, dass bei einer eingebauten Aktoreinheit ein Wärmeübergang vom Ausgleichszylinder zum Ventilgehäuse gegeben ist. Dabei ist es auch von Vorteil, dass die Federbleche jeweils aus dem Material Kupfer, Kupfer-Beryllium oder Bronze bestehen.

Eine weitere Ausführungsform der Erfindung zeichnet sich dadurch aus, dass in der Kopfplatte des Aktorgehäuses eine Nut zur Verstemmung der Aktoreinheit im Ventilgehäuse eingearbeitet ist.

Ein Ausführungsbeispiel der Erfindung wird im Folgenden anhand der Zeichnung näher erläutert. Es zeigen:
- Figur 1: die Aktoreinheit,
- Figur 2: einen Längsschnitt durch die Aktoreinheit gemäß Figur 1,
- Figur 3: einen weiteren Längsschnitt durch die Aktoreinheit gemäß Figur 1,
- Figur 4: ein Überblicksbild einer Aktoreinheit gemäß Figur 1 bis 3, und
- Figur 5: einen Teilausschnitt eines Einspritzventils.

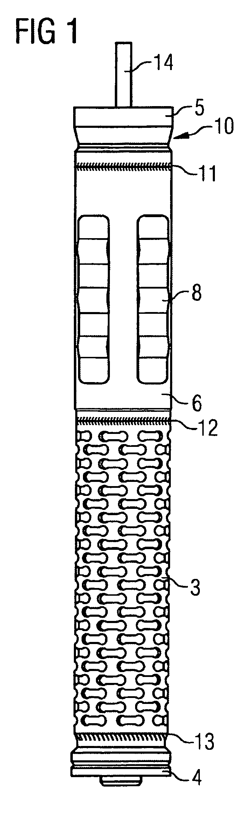

In Figur 1 ist die fertig montierte Aktoreinheit dargestellt, wobei zunächst die Teile des Aktorgehäuses, also Bodenplatte 4, daran angeschweißte Rohrfeder 3, daran angeschweißtes Verlängerungsrohr 6 und daran angeschweißte Kopfplatte 5, erkennbar sind. Die Kopfplatte 5 weist Bohrungen auf, aus denen Anschlussstifte 14 des Piezoaktors 1 herausgeführt sind. Angedeutet in Figur 1 sind ferner die Schweißnähte 11, 12 und 13 zur Verbindung der Teile 5, 6, 3 und 4 des Aktorgehäuses. Dargestellt in Figur 1 sind auch im Verlängerungsrohr 6 eingearbeitete Durchbrüche, in die Federbleche 8 aus Kupfer, Kupfer-Beryllium oder Bronze montiert werden. Diese Federbleche 8 sorgen für einen schnellen Wärmeübergang zwischen dem innenliegenden (hier nicht erkennbaren) Aluminium-Ausgleichszylinder und dem Ventilgehäuse, damit die Funktion der Längenkompensation bei Temperaturänderung optimal erfüllt werden kann.

Außerdem dargestellt in Figur 1 ist eine in die Kopfplatte 5 eingearbeitete Nut 10, die zur formschlüssigen Verstemmung der Aktoreinheit im Ventilgehäuse dienen kann.

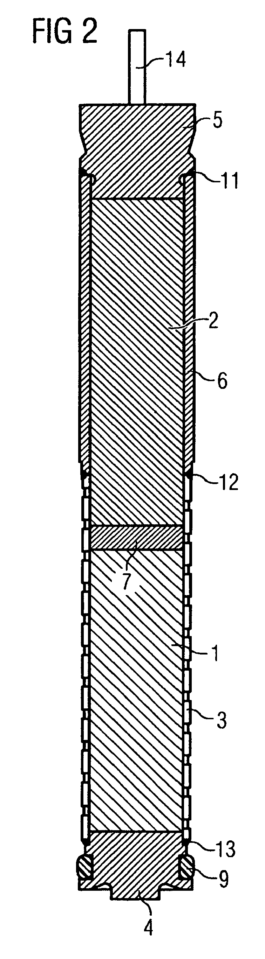

Figur 2 zeigt einen Querschnitt (senkrecht zur Ebene der Anschlussstifte 14) durch die Aktoreinheit. Erkennbar ist insbesondere der innere Aufbau der Aktoreinheit, bei dem der Piezoaktor 1, eine Zwischenscheibe 7 und der Aluminium-Ausgleichszylinder 2 in Reihe, axial hintereinander montiert sind. Diese inneren Teile 1, 7 und 2 werden vom Aktorgehäuse umschlossen, das aus der Bodenplatte 4, der Rohrfeder 3, dem Verlängerungsrohr 6 und der Deckplatte 5 besteht, die günstiger Weise aus miteinander verschweißten Stahlteilen bestehen, wodurch eine einheitliche, definierte thermische Längenausdehnung des Aktorgehäuses insgesamt resultiert. Der Verband aus Piezokeramik 1 und Aluminium 2ist also von einem gemeinsamen Stahlgehäuse 4, 3, 6 und 5 umschlossen, wobei die Gesamtausdehnung der inneren Teile 1, 7 und 2 im Wesentlichen derjenigen des Aktorgehäuses 4, 3, 6 und 5 entspricht, so dass auch bei Temperaturänderungen die vorgegebene Vorspannung des Piezoaktors 1 invariant bleibt.

In Figur 2 ist außerdem ein O-Ring 9 an der Bodenplatte 4 dargestellt, der die Zentrierung der Aktoreinheit in einer Bohrung des Injektorgehäuses erleichtert.

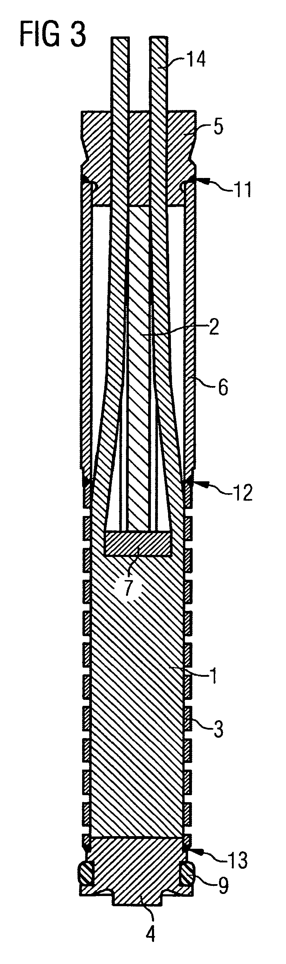

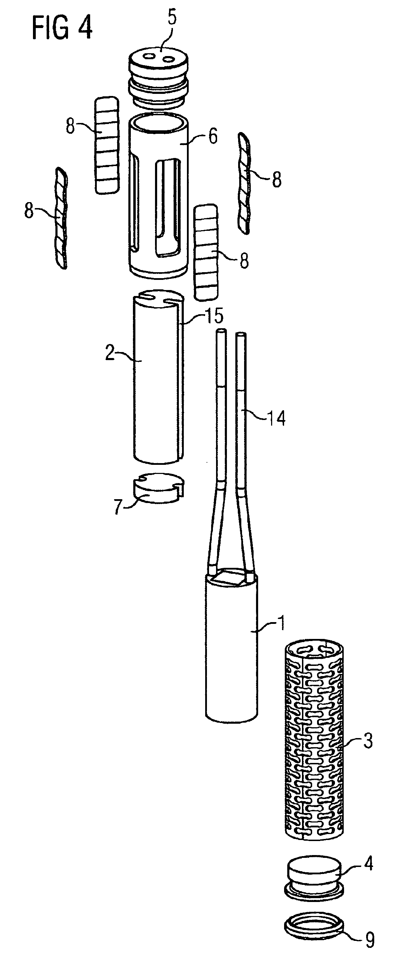

Figur 3 zeigt einen Querschnitt (entlang der von den Anschlussstiften 14 gebildete Ebene) durch die Aktoreinheit. In dieser Darstellung sind die durch die Bohrungen der Kopfplatte 5 hindurchgeführten und weiter in Seitenschlitzen 15 (vgl. Figur 4) des Aluminium-Ausgleichszylinders 2 geführten Anschlussstifte 14 des Piezoaktors 1 besonders gut zu erkennen.

Figur 4 zeigt den gesamten Aufbau der Aktoreinheit im Überblick. Zur Montage können zunächst die Kopfplatte 5 und das Verlängerungsrohr 6 durch eine Schweißnaht 11 verbunden werden. Danach wird die Rohrfeder 3 mit der Schweißnaht 12 an das Verlängerungsrohr 6 angeschweißt. Nun können die innenliegenden Teile, also der Piezoaktor 1 mit seinen Anschlüssen bzw. Anschlussstiften 14, die Zwischenscheibe 7 sowie der Aluminium-Ausgleichszylinder 2 mit jeweils für die Anschlussstifte 14 vorgesehenen Seitenschlitzen 15, in der aus den Teilen 3 und 6 zusammengesetzten Hülse mit bereits angeschweißter Kopfplatte 5 montiert werden. Schließlich kann die Bodenplatte 4 mittels der Schweißnaht 13, unter Aufbringung einer definierten Vorspannung auf die inneren Teile, insbesondere auf den Piezoaktor 1, mit der Rohrfeder 3 verbunden werden.

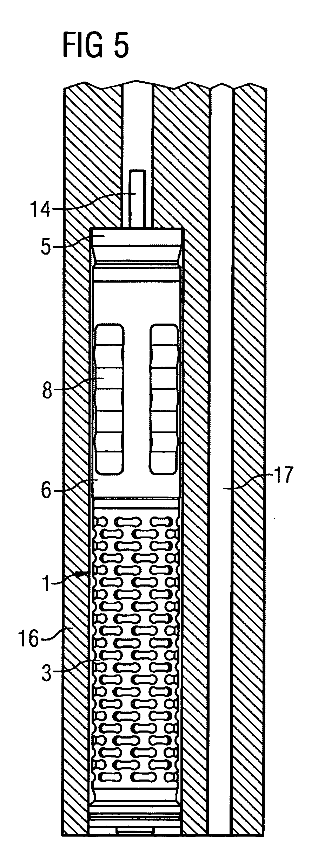

Abhängig von der gewählten Ausführungsform kann die Rohrfeder 3 und das Verlängerungsrohr 6 auch einstückig als ein Bauteil ausgeführt sein, wie in Figur 5 dargestellt ist. In Figur 5 ist ein Teil des Gehäuses 16 des Einspritzventils dargestellt. Im Gehäuse 16 ist eine Kraftstoffbohrung 17 ausgebildet, die Kraftstoff zu einer Düsennadel führt. Das Gehäuse 16 ist vorzugsweise im oberen Bereich des Einspritzventils angeordnet und der Piezoaktor 1 dient zur Betätigung eines Servoventils, das den Druck in einer Steuerkammer steuert. Die Düsennadel wird abhängig vom Druck in der Steuerkammer in eine Offen- oder eine Schließposition bewegt. In der Offenposition wird Kraftstoff abgegeben. Abhängig von der Ausführungsform kann der Piezoeaktor 1 die Düsennadel auch direkt steuern.

Insgesamt resultiert ein erfindungsgemäßes Einspritzventil mit einer kompakten, stabil im Injektor fixierbaren Antriebseinheit, deren Piezoaktor eine temperaturkonstante Vorspannung aufweist.

## Patentansprüche

1. Piezoaktor (1) für ein Kraftstoff-Einspritzventil, der unter Vorspannung in ein Aktorgehäuse eingebracht ist, wobei zwischen dem Piezoaktor (1) und einer Kopfplatte (5) des Aktorgehäuses ein Ausgleichselement zum Ausgleich der unterschiedlichen thermischen Längenänderung des Piezoaktors (1) gegenüber dem Aktorgehäuse angeordnet ist,
**dadurch gekennzeichnet, dass**
- der Piezoaktor (1) innerhalb einer Rohrfeder (3) angeordnet ist,
- das Ausgleichselement als innerhalb eines Verlängerungsrohres (6) angeordneter Ausgleichszylinder (2) ausgebildet ist,
- das Aktorgehäuse eine aus der Rohrfeder (3) und dem damit fest verbunden Verlängerungsrohr (6) bestehende Hülse (3, 6) umfasst, deren verlängerungsrohrseitiges Ende fest mit der Kopfplatte (5) und deren rohrfederseitiges Ende, unter Aufbringung einer definierten Vorspannung auf die innerhalb der Hülse (3, 6) axial hintereinander angeordneten Teile (1, 7, 2), fest mit einer Bodenplatte (4) des Aktorgehäuses (4, 3, 6, 5) verbunden ist.

2. Piezoaktor nach Anspruch 1,
**dadurch gekennzeichnet, dass** die Teile des Aktorgehäuses (4, 3, 6, 5) aus Stahl bestehen.

3. Piezoaktor nach Anspruch 1 oder 2,
**dadurch gekennzeichnet, dass** die Teile des Aktorgehäuses (4, 3, 6, 5) an den Verbindungsstellen miteinander verschweißt sind.

4. Piezoaktor nach einem der Ansprüche 1 bis 3,
**dadurch gekennzeichnet, dass** der Ausgleichszylinder (2) aus Aluminium besteht.

5. Piezoaktor nach einem der Ansprüche 1 bis 4,
**dadurch gekennzeichnet, dass** zwischen Piezoaktor (1) und Ausgleichszylinder (2) eine Zwischenscheibe (7) angeordnet ist.

6. Piezoaktor nach einem der Ansprüche 1 bis 5,
**dadurch gekennzeichnet, dass** im Umfang des Verlängerungsrohres (6) Durchbrüche eingearbeitet sind, in die jeweils ein Federblech (8) derart montiert ist, dass bei einer eingebauten Aktoreinheit ein Wärmeübergang vom Ausgleichszylinder (2) zu einem Gehäuse (16) des Einspritzventils gegeben ist.

7. Piezoaktor nach Anspruch 6,
**dadurch gekennzeichnet, dass** die Federbleche (8) jeweils aus dem Material Kupfer, Kupfer-Beryllium oder Bronze bestehen.

8. Piezoaktor nach einem der Ansprüche 1 bis 7,
**dadurch gekennzeichnet, dass** in der Kopfplatte (5) des Aktorgehäuses (4, 3, 6, 5) eine Nut (10) zur Verstemmung der Aktoreinheit im Ventilgehäuse eingearbeitet ist.

9. Einspritzventil mit einem Piezoaktor (1) gemäß einem der Ansprüche 1 bis 8.

## Claims

1. Piezo actuator (1) for a fuel injection valve which is inserted under pre-stressing into an actuator housing, with a compensation element to compensate for the different thermally-induced changes in length in relation to the actuator housing being incorporated between the piezo actuator (1) and a top plate (5) of the actuator housing.
**characterised in that**
- the piezo actuator (1) is arranged within a tubular spring (3),
- the compensating element is embodied as a compensating cylinder (2) arranged within an extension tube (6),
- the actuator housing comprises a sleeve (3, 6) consisting of the tubular spring (3) and the extension tube (6) fixed to it, the extension tube end of which is permanently connected to the top plate (5) and the tubular spring end of which, in exerting a defined pre-stressing on the parts (1, 7, 2) arranged axially behind each other within the sleeve (3, 6), is permanently connected to a base plate (4) of the actuator housing (4, 3, 6, 5).

2. Piezo actuator in accordance with claim 1,
**characterised in that** the parts of the actuator housing (4, 3, 6, 5) are made of steel.

3. Piezo actuator in accordance with claim 1 or 2,
**characterised in that** the parts of the actuator housing (4, 3, 6, 5) are welded to each other at their connecting points.

4. Piezo actuator in accordance with one of the claims 1 to 3,
**characterised in that** the compensating cylinder (2) are made of aluminium.

5. Piezo actuator in accordance with one of the claims 1 to 4,
**characterised in that** a spacer (7) is arranged between piezo actuator (1) and compensating cylinder (2).

6. Piezo actuator in accordance with one of the claims 1 to 5,
**characterised in that** breakthroughs are made in the circumference of the extension tube (6) in which a spring plate (8) is mounted in each case so that, with an actuator unit fitted, a heat transfer is produced from the compensating cylinder (2) to a housing (16) of the injection valve.

7. Piezo actuator in accordance with claim 6,
**characterised in that** the spring plates (8) are made of the material copper, copper-beryllium or bronze in each case.

8. Piezo actuator in accordance with one of the claims 1 to 7,
**characterised in that** a groove (1) for caulking the actuator unit in the valve housing is incorporated into the top plate (5) of the actuator housing (4, 3, 6, 5).

9. Injection valve with a piezo actuator (1) according to one of the claims 1 to 8.

## Revendications

1. Actionneur piézo-électrique (1) pour un injecteur de carburant, qui est emboîté sous précontrainte dans un boîtier d'actionneur, dans lequel, entre l'actionneur piézo-électrique (1) et une plaque de tête (5) du boîtier d'actionneur, est disposé un élément de compensation prévu pour compenser le fait que la variation thermique de la longueur de l'actionneur piézo-électrique (1) est différente de celle du boîtier d'actionneur,
**caractérisé en ce que**
- l'actionneur piézo-électrique (1) est disposé à l'intérieur d'un ressort tubulaire (3),
- l'élément de compensation est réalisé sous forme d'un cylindre de compensation (2) disposé à l'intérieur d'un tube prolongateur (6),
- le boîtier d'actionneur comprend une gaine (3, 6) composée du ressort tubulaire (3) et du tube prolongateur (6) relié rigidement à ce ressort, gaine dont l'extrémité côté tube prolongateur est reliée rigidement à la plaque de tête (5) et dont l'extrémité côté ressort tubulaire est reliée rigidement à une plaque de fond (4) du boîtier d'actionneur (4, 3, 6, 5), avec application d'une précontrainte définie sur les parties (1, 7, 2) disposées axialement l'une à la suite de l'autre à l'intérieur de la gaine (3, 6).

2. Actionneur piézo-électrique selon la revendication 1, **caractérisé en ce que** les parties du boîtier d'actionneur (4, 3, 6, 5) sont faites d'acier.

3. Actionneur piézo-électrique selon la revendication 1 ou 2,
**caractérisé en ce que** les parties du boîtier d'actionneur (4, 3, 6, 5) sont soudées les unes aux autres dans les zones d'assemblage.

4. Actionneur piézo-électrique selon une des revendications 1 à 3, **caractérisé en ce que** le cylindre de compensation (2) est fait d'aluminium.

5. Actionneur piézo-électrique selon une des revendications 1 à 4,
**caractérisé en ce qu'**un disque intermédiaire (7) est disposé entre l'actionneur piézo-électrique (1) et le cylindre de compensation (2).

6. Actionneur piézo-électrique selon une des revendications 1 à 5,
**caractérisé en ce que**, dans la périphérie du tube prolongateur (6), sont pratiquées des ouvertures dans chacune desquelles une tôle élastique (8) est montée de telle manière que, lorsqu'une unité actionneur est mise en place, il se produise une transmission de chaleur du cylindre de compensation (2) à un boîtier (16) de l'injecteur.

7. Actionneur piézo-électrique selon la revendication 6, **caractérisé en ce que** les tôles élastiques (8) sont faites à chaque fois de cuivre, de cuivre-béryllium ou de bronze.

8. Actionneur piézo-électrique selon une des revendications 1 à 7,
**caractérisé en ce que**, dans la plaque de tête (5) du boîtier d'actionneur (4, 3, 6, 5), est pratiquée une gorge (10) servant à sertir l'unité d'actionneur dans le boîtier d'injecteur.

9. Injecteur équipé d'un actionneur piézo-électrique (1) selon une des revendications 1 à 8.
